# EUROPÄISCHE PATENTSCHRIFT

(11) **EP 0 640 919 B1**
(45) Veröffentlichungstag und Bekanntmachung des Hinweises auf die Patenterteilung: **05.03.2003**
(21) Anmeldenummer: 94113538.6
(22) Anmeldetag: 30.08.1994
(51) Int. Cl.: G06F 11/22

(54) **Prozessorschaltung mit Testeinrichtung**
Processor circuit with a test device
Circuit ordinateur comportant un dispositif de test

(30) Priorität: 30.08.1993 DE 4329150
(43) Veröffentlichungstag der Anmeldung: 01.03.1995
(73) Patentinhaber: Infineon Technologies AG, 81669 München (DE)
(72) Erfinder: Caldera, Peter, Dipl.-Ing., A-9500 Villach (AT); Steiner, Markus, A-9524 St. Ulrich (AT)
(74) Vertreter: Charles, Glyndwr

(56) Entgegenhaltungen:
- US-A- 5 157 781
- YASUYUKI NOZUYAMA: "REALIZATION OF AN EFFICIENT DESIGN VERIFICATION TEST BASED ON A MICROINSTRUCTION CONTROLLED SELF TEST" PROCEEDINGS OF THE INTERNATIONAL TEST CONFERENCE, WASHINGTON, SEPT. 10 - 14, 1990, Nr. CONF. 21, 10.September 1990, INSTITUTE OF ELECTRICAL AND ELECTRONICS ENGINEERS, Seiten 327-336, XP000203667
- RITTER H C ET AL: "SELBSTTEST VON PROZESSOR-CHIPS" ELEKTRONIK, Bd. 39, Nr. 7, 30.März 1990, Seiten 38-40, 42 - 44, 46/47, XP000112972
- AGRAWAL V D ET AL: "A TUTORIAL ON BUILT-IN SELF-TEST PART 1: PRINCIPLES" IEEE DESIGN & TEST OF COMPUTERS, Bd. 10, Nr. 1, 1.März 1993, Seiten 73-82, XP000360901

## Beschreibung

Die Erfindung betrifft eine Prozessorschaltung mit einer Prozessorablaufsteuerung, mindestens einem über einen Bus damit verbundenen Schaltungsblock und einer Testeinrichtung.

Mit jedem neuen Technologieschritt steigt die Packungsdichte der Transistoren und sonstigen Bauelemente bei integrierten Schaltungen im allgemeinen und bei Prozessorschaltungen wie beispielsweise Mikroprozessoren, Signalprozessoren und Mikrokontrollern im Besonderen. Der Aufwand für die Entwicklung von Testprogrammen und die Erstellung von Prüfverfahren erreicht bereits heute Ausmaße, die mit dem eigentlichen Entwicklungsaufwand vergleichbar sind. Außerdem führt die fortschreitende Zunahme der Funktionalität zu einer logischen Tiefe, die das Ziel einer vollständigen Fehleraufdeckung in immer weitere Ferne rückt.

Die US-A-5,157,781 offenbart eine eingebaute Selbsttestfähigkeit (BIST; BIST = Built-In Self Test) für einen Mikrocomputer, bei der beispielsweise eine Zentralverarbeitungseinheit (CPU) mit Hilfe eines Testmoduls, das sich außerhalb der Zentralverarbeitungseinheit befindet und mit derselben über einen Zwischenmodulbus verbunden ist, getestet wird. Die Zentralverarbeitungseinheit weist eine Testabtaststeuerschaltung, die mit dem Zwischenmodulbus verbunden ist und darüber Testdaten bzw. Stimulus-Muster empfängt, und ein Testregister zum Speichern von Testdaten auf.

Die Aufgabe der Erfindung besteht darin, eine Prozessorschaltung anzugeben, die mit geringem Aufwand effizient testbar ist.

Die Aufgabe wird bei einer Prozessorschaltung der eingangs genannten Art durch eine Testeinrichtung gelöst, bei der jedem Schaltungsblock jeweils ein Testdecoder zugeordnet ist, der Steuersignale von einer ebenfalls an dem Bus angeschlossenen Testlogik sowie von der Prozessorablaufsteuerung erhält und danach den jeweiligen Schaltungsblock steuert, und bei der im Testbetrieb die Testlogik mittels der Steuersignale einem ausgewählten Schaltungsblock auswählt, alle anderen Schaltungsblöcke deaktiviert, über den Bus Testdaten an den bestimmten Schaltungsblock sendet, die Prozessorablaufsteuerung aktiviert, von dem ausgewählten Schaltungsblock modifizierte Testdaten über den Bus empfängt, diese auswertet und ein entsprechendes Ergebnissignal abgibt, wobei die Verarbeitung der Testdaten in dem ausgewählten Schaltungsblock durch die Prozessorablaufsteuerung bestimmt wird.

Die Erfindung, die durch Anspruch 1 definiert wird, ermöglicht es, digitale Bausteine mit integriertem Prozessorkern nach den gängigen Methoden für BuiltIn-Self-Test (BIST) zu testen. Das vorgestellte modulare Konzept bringt entscheidende Flächenvorteile mit sich, da im Gegensatz zu lokalen, d.h. den jeweils zu testenden Schaltungsblöcken zugeordneten BIST-Konzepten die Datenaufbereitung und die Datenkompression nur einmal an zentraler Stelle geschieht und die Prozessorablaufsteuerung sowie insbesondere der Mikrocode des Prozessors auch für den Test selbst verwendet wird. Daher ist eine spezielle Ansteuerung und ein spezielles Testmikroprogramm der zu testenden Schaltungsblöcke nicht notwendig. Da die ausgewählten Schaltungsblöcke immer das gesamte Mikroprogramm mit allen für den Normalbetrieb notwendigen Instruktionen durchlaufen werden, ist eine hinreichende Testabdeckung gewährleistet. Ein weiterer Vorteil besteht darin, daß der alle Schaltungsblöcke verbindende Bus mitgetestet wird.

Ausgestaltungen der Erfindung sehen vor, daß die Testlogik eine Testkontrolleinheit, durch die die Initialisierung, die Testablaufsteuerung und die Testauswertung erfolgt, ein Testmodusregister, in dem eine den ausgewählten Schaltungsblock entsprechende Adresse abgelegt wird, mindestens ein Testdatensenderegister, in dem die für den ausgewählten Schaltungsblock bestimmten Testdaten abgelegt werden, und mindestens ein Testdatenempfangsregister, in das die von dem ausgewählten Schaltungsblock gesendeten Testdaten zur Auswertung durch die Testkontrolleinheit eingegeben werden, aufweist. Bevorzugt wird dabei das Testdatenempfangsregister als über EXOR-Verknüpfungen rückgekoppelte Schieberegister mit mehreren Eingängen ausgeführt, welches die empfangenen Testdaten durch Modulo-2-Additionen mit einem Polynom in bekannter Weise zu einer Signatur komprimiert.

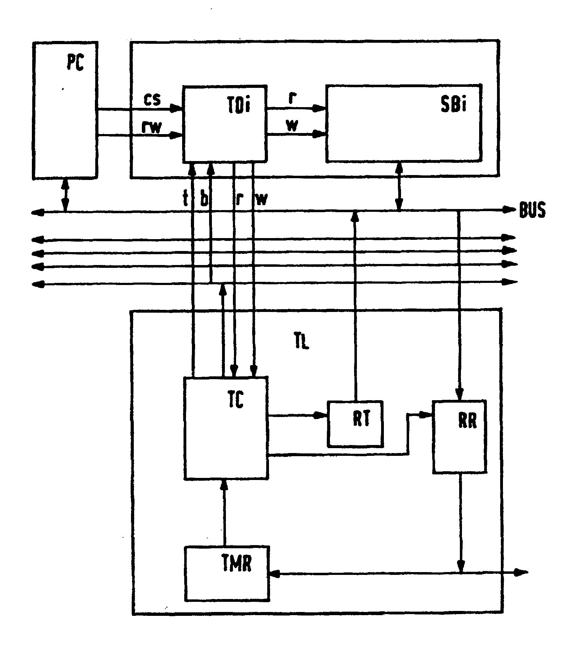

Die Erfindung wird nachfolgend anhand des in der einzigen Figur der Zeichung dargestellten Ausführungsbeispiels näher erläutert.

Bei der als Ausführungsbeispiel gezeigten Prozessorschaltung ist eine Prozessorablaufsteuerung PC über einen Bus BUS mit mehreren Schaltungsblöcken, von denen in der Zeichnung nur ein Schaltungsblock SBI ausgeführt ist, verbunden. Als Schaltungsblöcke sind dabei beispielsweise Arithmetikeinheiten (ALU), Nur-Lese-Speicher (ROM), Lese/Schreib-Speicher (RAM), Ein/Ausgabeeinheiten (IOM) usw. vorgesehen. Außerdem ist zum Zwecke eines Selbsttests eine Testeinrichtung gegeben, die aus einer zentralen Testlogik TL sowie lokalen Testdekodern besteht. In der Zeichnung ist wiederum nur ein Testdekoder, nämlich der dem Schaltungsblock SBi zugeordnete Testdekoder TDi gezeigt. Dabei sind alle Schaltungsblöcke mit der Testlogik TL über den Bus BUS sowie unter Zwischenschaltung der jeweiligen Testdekoder über Steuerleitungen verbunden. Von der Testlogik TL werden an den jeweiligen Testdekoder TDi ein Signal t, mit dem Normalbetrieb und Testbetrieb unterschieden werden, und ein Signal b, das den bestimmten Testdekoder TDi auswählt, übertragen. Vom Testdekoder TDi an die Testlogik TL werden Signale r und w übermittelt, die anzeigen, ob Daten in den Schaltungsblock SBi geschrieben oder aus diesem ausgelesen werden. Die Signale r und w liegen auch an dem Schaltungsblock SBi an.

Ob nun in den Schaltungsblock SBi geschrieben oder dieser ausgelesen wird, hängt von einem Blockauswahlsignal cs und einem Schreib-Lese-Signal rw ab, die von der Prozessorablaufsteuerung PC entsprechend dem in ihrem Mikroprogramm festgelegten Ablauf erzeugt werden.

Die Testlogik besteht bevorzugt aus einem Testkontroller TC, einem Testmodusregister TMR, einem Testdatensenderegister RT und einem Testdatenempfangsregister RR. Der Testkontroller TC beinhaltet die Steuerung des Testablaufs, d.h. die Initialisierung, die Testüberwachung und die Testdatenauswertung. In das Testmodusregister TMR werden in entsprechend kodierter Form der zu testende Schaltungsblock und gegebenenfalls zusätzlich kodierte Daten betreffend den Sendemodus des Testdatensenderegisters RT einprogrammiert. Dieses wiederum versorgt den bzw. die zu testenden Schaltungsblöcke mit den Teststimuli. Schließlich werden im Testdatenempfangsregister RR von dem ausgewählten Schaltungsblock TDi abgegebene Daten abgelegt. Das Testdatenempfangsregister RR besteht dabei bevorzugt aus einem bekannten Multiple-Input-Shift-Register (MISR), welches die in ihm abgelegten Testantworten der einzelnen Schaltungsblöcke durch Modulo-2-Additionen zu einer Signatur komprimiert.

Der Testablauf beginnt durch das Beschreiben des Testmodusregisters TMR, dessen Inhalt den zu testenden Schaltungsblock SBi und die Art der Testdatenübertragung festlegt. Gleichzeitig mit dem Einschreiben wird die Testkontrolleinheit TC aktiviert, die daraufhin dem ausgewählten Schaltungsblock SBi den Testbetriebsfall signalisiert. Damit werden alle anderen Schaltungsblöcke an Buszugriffen, insbesondere an Datenbuszugriffen, gehindert. Die Steuerleitungen für den Schaltungsblock SBi, beispielsweise einem Schreib/Lesespeicher (RAM), werden wie im Normalbetrieb abhängig vom Mikroprogramm der Prozessorablaufsteuerung PC durch diese angesteuert. Die Prozessorablaufsteuerung PC generiert dabei abhängig von ihrem Mikroprogramm in üblicher Weise das Blockauswahlsignal cs und ein Schreib- oder Lesesignal rw. Aus diesen Signalen cs und rw werden durch den jeweiligen Testdekoder TDi das Schreibsteuersignal w oder das Lesesteuersignal r abgeleitet und sowohl an den Schaltungsblock SBi als auch an die Testkontrolleinheit TC weitergeleitet und beiden damit die Richtung des Datenflusses angezeigt. Gegenüber dem Normalbetrieb werden die Daten nun jedoch nicht an einen anderen Schaltungsblock, beispielsweise der Arithmetikeinheit, mittels des Datenbusses übertragen, sondern es werden von der Testlogik TL Daten bereit gestellt und an den Schaltungsblock SBi übertragen und die durch diesen beispielsweise unveränderten, modifizierten oder neu generierten Daten von dem Schaltungsblock SBi an die Testlogik TL wieder zurückgesendet und anschließend durch diese ausgewertet. Die Steuerung des Testdatensenderegisters RT und des Testdatenempfangsregisters RR werden abhängig von den Signalen r und w durch die Testkontrolleinheit TC gesteuert. Nach einer bestimmten Anzahl von Zugriffen beendet die Testkontrolleinrichtung TC den Test und das Ergebnis (Signatur) kann über ein geeignets Interface beispielsweise einer Schnittstelle oder einem Mikrokontroller ausgelesen werden.

## Patentansprüche

1. Prozessorschaltung mit einer Prozessorablaufsteuerung (PC), mindestens einem Schaltungsblock (SBi), der über einen Datenbus (BUS) zum Übertragen von Daten zwischen mehreren Schaltungsblöcken (SBi) mit der Prozessorablaufsteuerung (PC) verbunden ist, und einer Testeinrichtung (Tl, TDi),
**gekennzeichnet durch** eine Testeinrichtung, bei der den Schaltungsblöcken (SBi) jeweils ein Testdekoder (TDi) zugeordnet ist, der Steuersignale (t, b, cs, rw) von einer ebenfalls an dem Datenbus (BUS) angeschlossenen Testlogik (TL) sowie von der Prozessorablaufsteuerung (PC) erhält und danach die Schaltungsblöcke (SBi) steuert, und bei der im Testbetrieb die Testlogik (TL) mittels der Steuersignale (t, b) einen bestimmten Schaltungsblock (SBi) auswählt, alle anderen Schaltungsblöcke deaktiviert, über den Datenbus (BUS) Testdaten an den ausgewählten Schaltungsblock (SBi) sendet, die Prozessorablaufsteuerung (PC) aktiviert, von dem ausgewählten Schaltungsblock (SBi) gesendete Testdaten über den Datenbus (BUS) empfängt, diese auswertet und ein entsprechendes Ergebnissignal abgibt, wobei die Verarbeitung der Testdaten in dem ausgewählten Schaltungsblock (SBi) **durch** die Prozessorablaufsteuerung (PC) bestimmt wird.

2. Prozessorschaltung nach Anspruch 1,
**dadurch gekennzeichnet, daß** die Testlogik (TL) eine Testkontrolleinheit (TC), durch die die Initialisierung, die Testablaufsteuerung und die Auswertung erfolgt, ein Testmodusregister (TMR), in dem eine dem ausgewählten Schaltungsblock (SBi) entsprechende Adresse abgelegt ist, mindestens ein Testdatensenderegister (RT), in dem die für den ausgewählten Schaltungsblock (SBi) bestimmten Testdaten abgelegt sind und mindestens ein Testdatenempfangsregister (RR), in das die von dem ausgewählten Schaltungsblock (SBi) modifizierten Daten zur Auswertung durch die Testkontrolleinheit (TC) eingegeben werden, aufweist.

3. Prozessorschaltung nach Anspruch 2,
**dadurch gekennzeichnet, daß** das Testdatenempfangsregister (RR) aus einem über EXOR-Verknüpfungen rückgekoppelten Schieberegister mit mehreren Eingängen besteht, das die modifizierten Testdaten durch Modulo-2-Additionen mit einem gegebenen Polynom komprimiert.

## Claims

1. Processor circuit having a processor flow controller (PC), at least one circuit block (SBi) which is connected to the processor flow controller (PC) via a data bus (BUS) for the purpose of transmitting data between a plurality of circuit blocks (SBi), and a test device (T1, TDi),
**characterized by** a test device in which the circuit blocks (SBi) have a respective associated test decoder (TDi) which receives control signals (t, b, cs, rw) from a test logic unit (TL), which is likewise connected to the data bus (BUS), and from the processor flow controller (PC) and then controls the circuit blocks (SBi), and in which, in the test mode, the test logic unit (TL) uses the control signals (t, b) to select a particular circuit block (SBi), deactivates all the other circuit blocks, sends test data to the selected circuit block (SBi) via the data bus (BUS), activates the processor flow controller (PC), receives test data sent by the selected circuit block (SBi) via the data bus (BUS), evaluates them and outputs a corresponding result signal, the processing of the test data in the selected circuit block (SBi) being determined by the processor flow controller (PC).

2. Processor circuit according to Claim 1,
**characterized in that** the test logic unit (TL) has a test control unit (TC) which performs initialization, test flow control and evaluation, a test mode register (TMR) storing an address which corresponds to the selected circuit block (SBi), at least one test data transmission register (RT) storing the test data intended for the selected circuit block (SBi), and at least one test data reception register (RR) into which the data modified by the selected circuit block (SBi) are input for evaluation by the test control unit (TC).

3. Processor circuit according to Claim 2,
**characterized in that** the test data reception register (RR) comprises a shift register having a plurality of inputs which is fed back via EXOR gates and compresses the modified data using modulo-2 additions with a given polynomial.

## Revendications

1. Circuit de processeur ayant une commande d'exploitation (PC), au moins un bloc de circuit (SBi), qui est connecté, via un bus de données (BUS) pour le transfert de données entre plusieurs blocs de circuit (SBi), à la commande d'exploitation du processeur (PC), et un dispositif de test (TL, TDi), **caractérisé par** un dispositif de test, dans lequel est affecté aux blocs de circuit (SBi) respectivement un décodeur de test (TDi), qui reçoit des signaux de commande (t, b, cs, rw) d'un circuit logique de test (TL) connecté également au bus de données (BUS) ainsi que de la commande d'exploitation du processeur (PC) et commande en fonction de ces signaux les blocs de circuit (SBi), et dans lequel, en mode de test, le circuit logique de test (TL) sélectionne au moyen des signaux de commande (t, b) un bloc de circuit déterminé (SBi), désactive tous les autres blocs de circuit, envoie des données de test via le bus de données (BUS) au bloc de circuit sélectionné (SBi), active la commande d'exploitation du processeur (PC), reçoit des données de test envoyées par le bloc de circuit sélectionné (SBi) via le bus de données (BUS), les exploite et délivre un signal de résultat correspondant, le traitement des données de test dans le bloc de circuit sélectionné (SBi) étant déterminé par la commande d'exploitation du processeur (PC).

2. Circuit de processeur selon la revendication 1, **caractérisé en ce que** le circuit logique de test (TL) présente une unité de contrôle de test (TC), qui permet l'initialisation, la commande de déroulement du test et l'exploitation, un registre de mode de test (TMR), dans lequel est stockée une adresse correspondant au bloc de circuit sélectionné (SBi), au moins un registre d'envoi de données de test (RT), dans lequel sont stockées les données de test déterminées pour le bloc de circuit sélectionné (SBi), et au moins un registre de réception de données de test (RR), dans lequel sont introduites les données modifiées par le bloc de circuit sélectionné (SBi) pour exploitation par l'unité de contrôle de test (TC).

3. Circuit de processeur selon la revendication 2, **caractérisé en ce que** le registre de réception de données de test (RR) est constitué d'un registre à décalage à rétroaction via des combinaisons OU exclusif avec plusieurs entrées, qui comprime les données de test modifiées par des additions modulo-2 avec un polynôme donné.
